# EUROPÄISCHE PATENTANMELDUNG

(11) **EP 1 091 407 A1**
(43) Veröffentlichungstag der Anmeldung: **11.04.2001**
(21) Anmeldenummer: 99119636.1
(22) Anmeldetag: 04.10.1999
(51) Int. Cl.: H01L 23/60, H01C 7/105

(54) **Überspannungsschutzanordnung für Halbleiterbausteine**

(71) Anmelder: Infineon Technologies AG, 81669 München (DE)
(72) Erfinder: Hochdorfer, Bernhard, 89231 Neu-Ulm (DE)
(74) Vertreter: Hermann, Uwe, Dipl.-Ing.

(57) **Zusammenfassung**

Die Erfindung betrifft eine Überspannungsschutzanordnung für Halbleiterbausteine, insbesondere Sensor-Bausteine, bei der eine anisotrope Schutzschicht (6) vorgesehen ist, die bei niedrigen elektrischen Feldstärken nichtleitend und bei hohen elektrischen Feldstärken leitend ist.

## Beschreibung

Die vorliegende Erfindung betrifft eine Überspannungsschutzanordnung für Halbleiterbausteine, bei der ein Halbleiterbaustein wenigstens teilweise mit einer Schutzschicht umgeben ist.

Halbleiterbausteine und insbesondere integrierte Bausteine, wie z.B. Sensor-Bausteine, werden gewöhnlich zu ihrem Schutz vor Umwelteinflüssen in einem Gehäuse untergebracht. Ein solches Gehäuse kann beispielsweise aus Kunststoff oder Keramik bestehen.

In den meisten Fällen umgibt das Gehäuse vollständig einen integrierten Baustein, so daß nur dessen elektrische Anschlüsse zugänglich sind. Diese elektrischen Anschlüsse müssen gegen elektrostatische Schockbeanspruchungen geschützt werden, da solche den Baustein zerstören würden.

In letzter Zeit wurden nun Sensor-Bausteine entwickelt, die nicht mehr vollständig in Gehäusen untergebracht sind, sondern teilweise freiliegen. Dies ist erforderlich, damit der Sensor-Baustein seine Funktionen erfüllen kann. Mit anderen Worten, bei diesen Sensor-Bausteinen liegen nicht nur die elektrischen Anschlüsse, sondern auch ein Teil der Oberfläche des Bausteins, also des Chips, frei, so daß die Chipoberfläche teilweise von außen zugänglich ist. Dies bedeutet aber, daß auch die Chipoberfläche gegen elektrostatische Aufladung und Entladung geschützt werden muß.

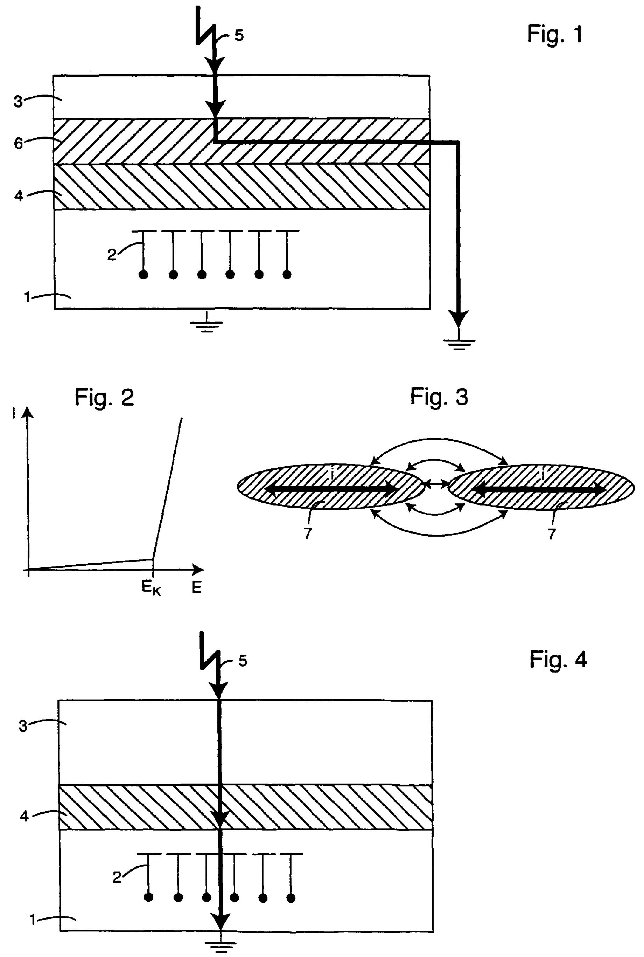

Fig. 4 zeigt eine herkömmliche Schutzanordnung für einen integrierten Baustein. Auf einem Halbleiterchip 1, in dem eine nicht gezeigte elektrische Schaltung realisiert ist und der über elektrische Anschlüsse 2 verfügt, sind der Reihe nach von außen nach innen ein erster Schutzfilm 3, der als Kratzschutz dient, und ein zweiter Schutzfilm 4 gegen Feuchtigkeit vorgesehen. Tritt eine Überspannung auf, was durch einen Pfeil 5 veranschaulicht ist, so dringt diese Überspannung durch die beiden Schutzfilme 3, 4 bis zu dem Halbleiterchip 1 vor und wird über diesen abgeleitet. Dadurch wird der Halbleiterchip 1 mit der in ihm enthaltenen integrierten Schaltung und gegebenenfalls einem Sensor beschädigt oder sogar zerstört.

Gehäuse integrierter Halbleiterbausteine enthalten zum Schutz der elektrischen Anschlüsse mehrstufige, platzaufwendige Schutzstrukturen, die in der Lage sind, die Chips der Bausteine gegen Aufladungen bis zu etwa 4 kV zu schützen. Derartige bestehende Schutzstrukturen sind aber für Halbleiterbausteine mit teilweise freiliegender Oberfläche, also für offene Bausteine, an deren freiliegender oder aktiver Chipoberfläche ungeeignet, da sie entweder die Funktion dieser Bausteine stark einschränken oder sogar die Funktion der Bausteine vollständig vernichten würden, wie beispielsweise die Kapazität von Sensor-Bausteinen. Außerdem ist der Platzbedarf solcher bestehender Schutzstrukturen auf der Chipoberfläche äußerst groß.

Es ist daher Aufgabe der vorliegenden Erfindung, eine Überspannungsschutzanordnung für Halbleiterbausteine anzugeben, die in der Lage ist, auf einfache Weise die gesamte, in dem Halbleiterbaustein realisierte Schaltung vor einer Zerstörung durch Überspannungen zu schützen.

Diese Aufgabe wird bei einer Überspannungsschutzanordnung der eingangs genannten Art erfindungsgemäß dadurch gelöst, daß die Schutzschicht aus einem Material hergestellt ist, das bei niedrigen elektrischen Feldstärken nichtleitend und bei hohen elektrischen Feldstärken leitend ist.

Für ein derartiges Material kann in vorteilhafter Weise Kunststoff, Keramik oder ein Verbundwerkstoff gewählt werden.

Dabei sind in einem Verbundwerkstoff in vorteilhafter Weise reiskornförmige Hilfsstoffe eingebracht, die die Leitfähigkeit unterstützen und speziell die elektrische Feldstärke in der Ebene der Schutzschicht verstärken. Solche Hilfsstoffe sind beispielsweise feine Metallpartikel aus insbesondere Aluminium.

Das erfindungsgemäß für die Schutzschicht verwendete Material weist bei niedrigen elektrischen Feldstärken einen möglichst hohen elektrischen Widerstand auf. Dies ist Voraussetzung, daß der Halbleiterbaustein, beispielsweise ein Sensor-Baustein, seine Funktionen zu erfüllen vermag. Nach Erreichen einer Auslösefeldstärke muß der elektrische Widerstand aber möglichst gering werden, damit die Überspannung über das Gehäuse abgeleitet werden kann und der Halbleiterchip im Gehäuse nicht geschädigt wird.

Schließlich ist in vorteilhafter Weise die erfindungsgemäße Schutzschicht zwischen dem ersten Schutzfilm für einen Kratzschutz und dem zweiten Schutzfilm gegen Feuchtigkeit vorgesehen. Gegebenenfalls können diese drei Schutzschichten bzw. -filme auch miteinander integriert oder in anderer Reihenfolge angeordnet sein.

Nachfolgend wird die Erfindung anhand der Zeichnungen näher erläutert. Es zeigen:
- Fig. 1: eine schematische Schnittdarstellung zur Erläuterung der erfindungsgemäßen Überspannungsschutzanordnung,
- Fig. 2: den Verlauf einer Kennlinie des für die Schutzschicht verwendeten Materials,
- Fig. 3: eine Einzelheit zur Erläuterung des Aufbaues eines Verbundwerkstoffes für die bei der erfindungsgemäßen Überspannungsschutzanordnung verwendete Schutzschicht und
- Fig. 4: eine schematische Schnittdarstellung zur Erläuterung einer bestehenden Überspannungsschutzanordnung.

Die Fig. 4 ist bereits eingangs erläutert worden. In den Figuren werden für einander entsprechende Bauteile jeweils die gleichen Bezugszeichen verwendet.

Fig. 1 zeigt eine schematische Schnittdarstellung durch die erfindungsgemäße Überspannungsschutzanordnung. Zwischen dem als Kratzschutz dienenden ersten Schutzfilm 3 aus beispielsweise einem Fettfilm und dem als Feuchtigkeitsschutz dienenden zweiten Schutzfilm 4 aus beispielsweise Siliziumnitrid oder Polyimid ist hier erfindungsgemäß noch eine anisotrope Schutzschicht 6 vorgesehen, die aus einem Material hergestellt ist, das bei niedrigen elektrischen Feldstärken nichtleitend und bei hohen elektrischen Feldstärken leitend ist. Trifft eine Überspannung auf den Halbleiterbaustein auf (vgl. Pfeil 5), so dringt diese Überspannung bis zu der anisotropen Schutzschicht 6 vor, die dann infolge der durch die Überspannung hervorgerufenen hohen Feldstärke leitend wird und damit die Überspannung ableitet, so daß eine Schädigung des Halbleiterchips 1 zuverlässig verhindert wird. Mit anderen Worten, die Überspannung wird um den Halbleiterchip 1 herum abgeleitet, so daß der Halbleiterchip bzw. die in ihm realisierte integrierte Schaltung nicht angegriffen wird.

Liegen Teile der Oberfläche des Halbleiterchips 1 frei, damit beispielsweise ein im Halbleiterchip 1 realisierter Sensor seine Funktion zu erfüllen vermag, dann gewährleistet die um den freiliegenden Teil der Oberfläche des Halbleiterchips 1 herum geführte anisotrope Schutzschicht 6 einen zuverlässigen Schutz der freiliegenden Oberfläche, da sie ein Eindringen der Überspannung in den Halbleiterchip 1 abschirmt.

Als Material für die Schutzschicht 6 kann ein Kunststoff, wie beispielsweise ein Polymer, eine Keramik oder ein Verbundwerkstoff, wie beispielsweise Polymer mit Metallpartikeln aus z.B. Aluminium gewählt werden. In einem Verbundwerkstoff sind in vorteilhafter Weise reiskornförmige (auch sphärische, zylinderförmige oder stäbchenförmige) elektrisch leitende Hilfsstoffe eingelagert, die die Leitfähigkeit in der Ebene der Schutzschicht 6 verbessern. Solche reiskornförmigen Hilfsstoffe bestehen beispielsweise aus Metall, Halbleiter oder Ruß. Geeignete Polymere sind Epoxide, Amine, Acrylate sowie Derivate hiervon.

Fig. 3 zeigt ein Beispiel für diese reiskornförmigen Hilfsstoffe. Körner 7 aus beispielsweise Metall sind mit ihren Flachseiten in der Ebene der Schutzschicht 6 angeordnet. Liegt ein hohes elektrisches Feld an, so tritt eine elektrische Leitung zwischen den Körnern 7 auf. Damit kann ein Strom i über die Körner 7 abgeleitet werden. Ein geeignetes Metall für die Körner 7 ist Aluminium. Geeignete Abmessungen für die Körner liegen zwischen 10 nm und 100 um, bevorzugt zwischen 1 und 10 µm.

Wie bereits oben erläutert wurde, soll das für die Schutzschicht 6 verwendete Material ab einer bestimmten kritischen elektrischen Feldstärke Eₖ möglichst hoch leitend sein. Unterhalb dieser kritischen elektrischen Feldstärke Eₖ soll aber der elektrische Widerstand des Materials möglichst hoch sein, damit die in dem Halbleiterchip 1 realisierte integrierte Schaltung, bzw. der darin ausgeführte Sensor ihre bzw. seine Funktion zu erfüllen vermag. Nach Erreichen der kritischen elektrischen Feldstärke Eₖ wird der Widerstand des Materials aber äußerst gering, damit die Überspannung über die Schutzschicht 6 abgeleitet werden kann und der Halbleiterchip 1 nicht beschädigt wird. Fig. 2 zeigt nun den Verlauf eines Stromes I in dem Material in Abhängigkeit von der in dem Material herrschenden elektrischen Feldstärke E: wie zu ersehen ist, steigt ab einer kritischen Feldstärke Ek der Strom I steil an. Unterhalb dieser kritischen elektrischen Feldstärke Eₖ hat der Strom I aber nur sehr kleine Werte.

## Patentansprüche

1. Überspannungsschutzanordnung für Halbleiterbausteine, bei der ein Halbleiterbaustein wenigstens teilweise mit einer Schutzschicht (6) umgeben ist,
**dadurch gekennzeichnet** , daß die Schutzschicht (6) aus einem Material hergestellt ist, das bei niedrigen elektrischen Feldstärken nichtleitend und bei hohen elektrischen Feldstärken leitend ist.

2. Überspannungsschutzanordnung nach Anspruch 1,
**dadurch gekennzeichnet** , daß das Material der Schutzschicht (6) aus Kunststoff, Keramik oder einem Verbundwerkstoff besteht.

3. Überspannungsschutzanordnung nach Anspruch 2,
**dadurch gekennzeichnet** , daß in den Verbundwerkstoff reiskornförmige Hilfsstoffe (7) eingelagert sind, die die Leitfähigkeit in der Ebene der Schutzschicht (6) verstärken.

4. Überspannungsschutzanordnung nach Anspruch 3,
**dadurch gekennzeichnet**, daß die Hilfsstoffe aus feinen Metallpartikeln aus insbesondere Aluminium bestehen.

5. Überspannungsschutzanordnung nach einem der Ansprüche 1 bis 4,
**dadurch gekennzeichnet**, daß die Schutzschicht aus einem Polymer besteht.

6. Überspannungsschutzanordnung nach einem der Ansprüche 1 bis 5,
**dadurch gekennzeichnet**, daß die Schutzschicht (6) zwischen einem ersten Schutzfilm (3) für Kratzschutz und einem zweiten Schutzfilm (4) gegen Feuchtigkeit vorgesehen ist.

7. Überspannungsschutzanordnung nach Anspruch 6,
**dadurch gekennzeichnet**, daß der erste Schutzfilm (3) aus einem Fettfilm besteht.

8. Überspannungsschutzanordnung nach Anspruch 6 oder 7,
**dadurch gekennzeichnet**, daß der zweite Schutzfilm (4) aus Siliziumnitrid oder Polyimid besteht.
